# EUROPEAN PATENT SPECIFICATION

(11) **EP 4 374 284 B1**
(45) Date of publication and mention of the grant of the patent: **18.11.2026**
(21) Application number: 21786283.8
(22) Date of filing: 27.08.2021
(51) Int. Cl.: G06F 30/30

(54) **DISTRIBUTION ESTIMATION OF MANUFACTURING VARIABILITY CHARACTERISTICS THROUGH QUANTILE SAMPLING**
SCHÄTZUNG DER VERTEILUNG VON MERKMALEN DER FERTIGUNGSVARIABILITÄT DURCH QUANTILSTICHPROBEN
ESTIMATION DE LA DISTRIBUTION DES CARACTÉRISTIQUES DE VARIABILITÉ DE LA FABRICATION PAR ÉCHANTILLONNAGE QUANTILE

(43) Date of publication of application: 29.05.2024
(73) Proprietor: Siemens Industry Software Inc., Plano, TX 75024-6612 (US)
(72) Inventor: COOPER, James, Saskatoon, Saskatchewan S7N 4X6 (CA)
(74) Representative: HKW Intellectual Property PartG mbB
(86) International application number: PCT/US2021/047845
(87) International publication number: WO 2023/027714

(56) References cited:
- US-B1- 10 803 218

## Description

### TECHNICAL FIELD

This application is generally related to electronic design automation and, more specifically, to distribution estimation of manufacturing variability characteristics through quantile sampling.

### BACKGROUND

Many designers utilize libraries of standard cells to build circuit designs for electronic devices. The standard cells in these libraries typically include descriptions of digital circuitry and their various characteristics, such as timing information, power estimation, functionality, operating conditions, or the like, which can be specified using a Liberty format. For example, the Liberty format can include lookup tables populated with timing information of the standard cells in the libraries, such as cell delays, transition times and setup and hold constraints, or the like.

Since timing and power characteristics of digital circuits can vary in manufactured electronic devices, often called on-chip variation (OCV), the standard cell descriptions can also include statistical variation information, for example, specified in a Liberty Variation Format (LVF) extension to the Liberty format, which models the impacts of manufacturing-related variation associated with on-chip variation. The designers typically utilize the statistical variation information during a Statistical Timing Analysis (STA) to account for the impact that manufacturing-related variation has on delays in timing paths of the circuit designs during functional verification.

US 10,803,218 B1 relates to systems and methods for simulating quantile behavior of a physical system. A plurality of parameter samples to a physical system are accessed and a subset of the parameter samples are identified, each of the plurality of parameter samples including a variation of parameters for the physical system. The physical system is simulated based on the subset of the parameter samples to generate simulation results, each of the subset of the parameter samples corresponding to a respective one of the simulation results. A neural network is trained to predict the simulation results based on the subset of the parameter samples. Simulation results are predicted for the plurality of parameter samples based on the neural network which has been trained, each of the predicted simulation results corresponding to a respective one of the plurality of parameter samples, and an indicator is generated indicating a quantile simulation result of the physical system according to an ordering relationship among the plurality of simulation results.

A common technique used to characterize standard cells and generate the statistical variation information includes identifying random samples of manufacturing-related variation, for example, through Monte Carlo sampling, and then individually applying the characteristics of the random samples to the digital circuitry of the standard cell and simulating the digital circuitry of the standard cell using an analog simulator. In order to have an accurate estimate of the impact of the variation, for example, a +/- 3 sigma value, the analog simulator would have to perform approximately 10,000 simulations per measurement, which can be processing intensive and impractical to characterize the millions of different measurements in a standard cell library. For that reason, some designers elect to perform 1,000-2,000 simulations, at most, and then extrapolate the results. As the size of the electronic devices has become smaller, the extrapolated results have become less accurate causing issues with timing closure and silicon failure. Other designers have attempted to speed up the characterization process by generating models of the standard cells, which can be simulated more quickly, and then simulating the model rather than the standard cells. While this characterization approach can reduce overall simulation time, it remains processing intensive and can still consumes weeks of the development timeframe.

### SUMMARY

The invention is defined by the attached set of claims. Further details of the disclosed method, devices and system are described below, which are helpful for understanding the claimed invention.

This application discloses a computing system implementing a design characterization tool can sample a distribution of values for manufacturing variation of an integrated circuit described by a circuit design. The design characterization tool can order the samples based on predicted output values of the circuit design. The computing system can implement an analog simulator to simulate the circuit design utilizing a subset of the samples of values for manufacturing variation to identify simulated output values for an output distribution model. The design characterization tool can estimate an error in the order of the samples associated with the predicted outputs of the circuit design based on the simulated output values in the output distribution model. The design characterization tool can modify the output distribution model to correct a bias based on the estimated error in the order of the samples, wherein the modified output distribution is utilized to characterize operational variation of the circuit design to the manufacturing variation described in the distribution of the values. Embodiments of will be described below in greater detail.

### DESCRIPTION OF THE DRAWINGS

Figures 1 and 2 illustrate an example of a computer system of the type that may be used to implement various embodiments.
Figure 3 illustrates an example design characterization tool to estimate a distribution of manufacturing variability characteristics through quantile sampling that may be implemented according to various embodiments.
Figure 4 illustrates a flowchart showing an example implementation of estimating a distribution of manufacturing variability characteristics through quantile sampling according to various examples.
Figure 5 illustrates a flowchart showing an example of error estimation in an ordering of samples and corresponding distribution model correction according to various examples.

### DETAILED DESCRIPTION

### Illustrative Operating Environment

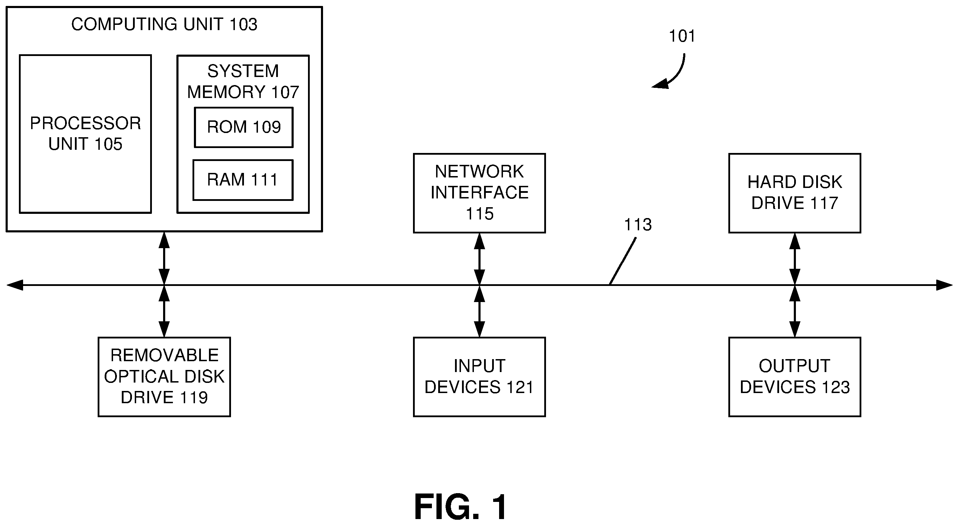

Various examples may be implemented through the execution of software instructions by a computing device 101, such as a programmable computer. Accordingly, Figure 1 shows an illustrative example of a computing device 101. As seen in this figure, the computing device 101 includes a computing unit 103 with a processor unit 105 and a system memory 107. The processor unit 105 may be any type of programmable electronic device for executing software instructions, but will conventionally be a microprocessor. The system memory 107 may include both a read-only memory (ROM) 109 and a random access memory (RAM) 111. As will be appreciated by those of ordinary skill in the art, both the read-only memory (ROM) 109 and the random access memory (RAM) 111 may store software instructions for execution by the processor unit 105.

The processor unit 105 and the system memory 107 are connected, either directly or indirectly, through a bus 113 or alternate communication structure, to one or more peripheral devices 115-123. For example, the processor unit 105 or the system memory 107 may be directly or indirectly connected to one or more additional memory storage devices, such as a hard disk drive 117, which can be magnetic and/or removable, a removable optical disk drive 119, and/or a flash memory card. The processor unit 105 and the system memory 107 also may be directly or indirectly connected to one or more input devices 121 and one or more output devices 123. The input devices 121 may include, for example, a keyboard, a pointing device (such as a mouse, touchpad, stylus, trackball, or joystick), a scanner, a camera, and a microphone. The output devices 123 may include, for example, a monitor display, a printer and speakers. With various examples of the computing device 101, one or more of the peripheral devices 115-123 may be internally housed with the computing unit 103. Alternately, one or more of the peripheral devices 115-123 may be external to the housing for the computing unit 103 and connected to the bus 113 through, for example, a Universal Serial Bus (USB) connection.

With some implementations, the computing unit 103 may be directly or indirectly connected to a network interface 115 for communicating with other devices making up a network. The network interface 115 can translate data and control signals from the computing unit 103 into network messages according to one or more communication protocols, such as the transmission control protocol (TCP) and the Internet protocol (IP). Also, the network interface 115 may employ any suitable connection agent (or combination of agents) for connecting to a network, including, for example, a wireless transceiver, a modem, or an Ethernet connection. Such network interfaces and protocols are well known in the art, and thus will not be discussed here in more detail.

It should be appreciated that the computing device 101 is illustrated as an example only, and it not intended to be limiting. Various embodiments may be implemented using one or more computing devices that include the components of the computing device 101 illustrated in Figure 1, which include only a subset of the components illustrated in Figure 1, or which include an alternate combination of components, including components that are not shown in Figure 1. For example, various embodiments may be implemented using a multi-processor computer, a plurality of single and/or multiprocessor computers arranged into a network, or some combination of both.

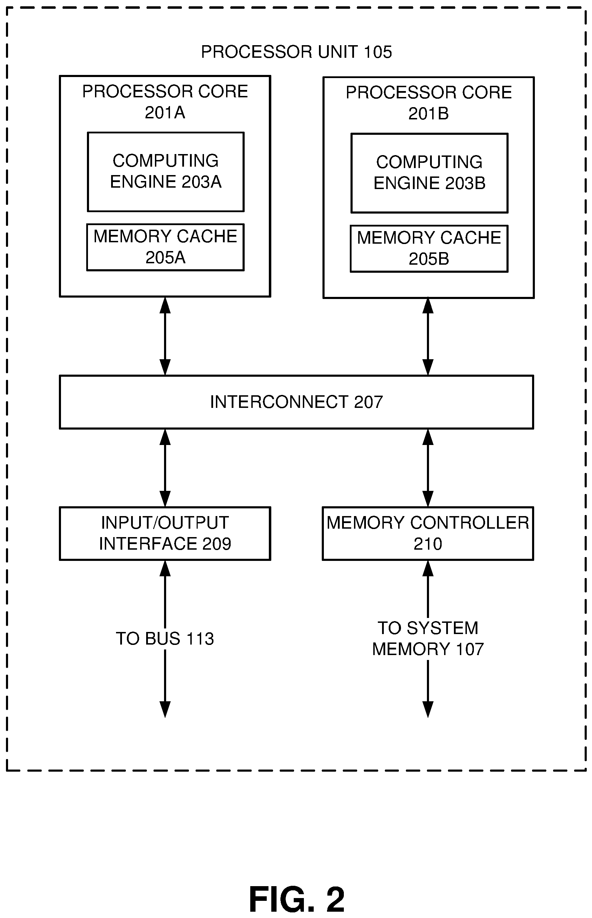

With some implementations, the processor unit 105 can have more than one processor core. Accordingly, Figure 2 illustrates an example of a multi-core processor unit 105 that may be employed with various embodiments. As seen in this figure, the processor unit 105 includes a plurality of processor cores 201A and 201B. Each processor core 201A and 201B includes a computing engine 203A and 203B, respectively, and a memory cache 205A and 205B, respectively. As known to those of ordinary skill in the art, a computing engine 203A and 203B can include logic devices for performing various computing functions, such as fetching software instructions and then performing the actions specified in the fetched instructions. These actions may include, for example, adding, subtracting, multiplying, and comparing numbers, performing logical operations such as AND, OR, NOR and XOR, and retrieving data. Each computing engine 203A and 203B may then use its corresponding memory cache 205A and 205B, respectively, to quickly store and retrieve data and/or instructions for execution.

Each processor core 201A and 201B is connected to an interconnect 207. The particular construction of the interconnect 207 may vary depending upon the architecture of the processor unit 105. With some processor cores 201A and 201B, such as the Cell microprocessor created by Sony Corporation, Toshiba Corporation and IBM Corporation, the interconnect 207 may be implemented as an interconnect bus. With other processor units 201A and 201B, however, such as the Opteron^{™} and Athlon^{™} dual-core processors available from Advanced Micro Devices of Sunnyvale, California, the interconnect 207 may be implemented as a system request interface device. In any case, the processor cores 201A and 201B communicate through the interconnect 207 with an input/output interface 209 and a memory controller 210. The input/output interface 209 provides a communication interface to the bus 113. Similarly, the memory controller 210 controls the exchange of information to the system memory 107. With some implementations, the processor unit 105 may include additional components, such as a high-level cache memory accessible shared by the processor cores 201A and 201B. It also should be appreciated that the description of the computer network illustrated in Figure 1 and Figure 2 is provided as an example only, and is not intended to suggest any limitation as to the scope of use or functionality of alternate embodiments.

### Distribution Estimation of Manufacturing Variability Characteristics Through Quantile Sampling

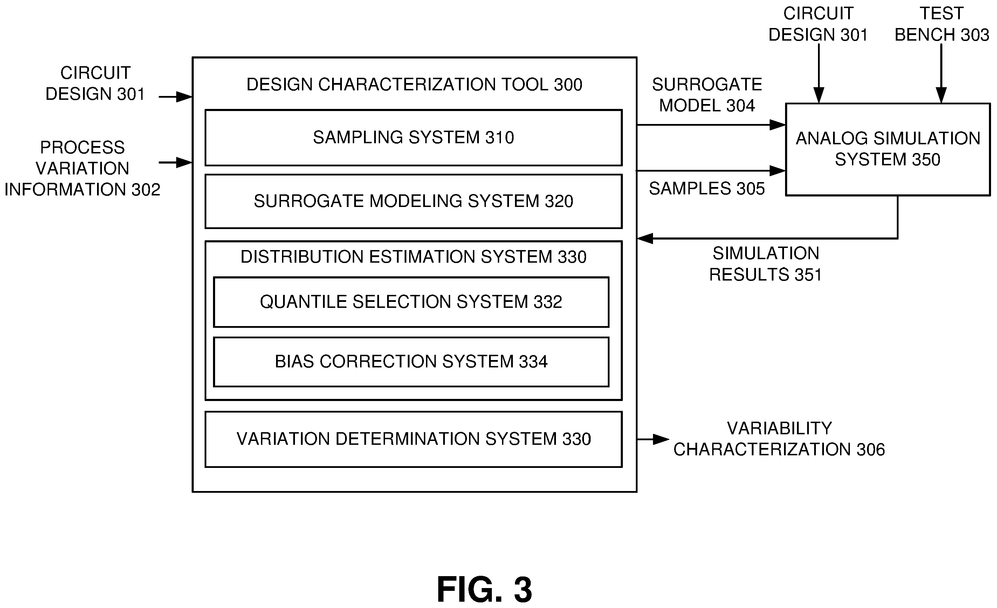

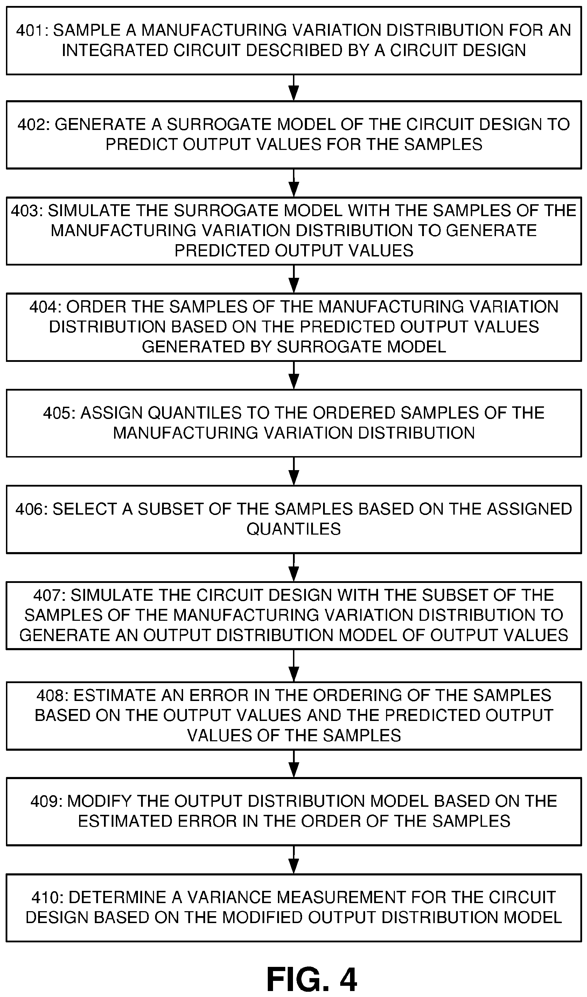

Figure 3 illustrates an example design characterization tool 300 to estimate a distribution of manufacturing variability characteristics through quantile sampling that may be implemented according to various embodiments. Figure 4 illustrates a flowchart showing an example implementation of estimating a distribution of manufacturing variability characteristics through quantile sampling according to various examples. Referring to Figures 3 and 4, a design characterization tool 300, for example, implemented with the computing device 101 described in Figure 1, can receive a circuit design 301 describing an electronic device, such as an integrated circuit, in a transistor-level netlist format. The circuit design 301 can correspond to transistor-level netlists describing electronic circuits using metal-oxide-semiconductor (MOS) transistors, resistances, capacitors, inductances, or the like, for example, in a Simulation Program with Integrated Circuit Emphasis (SPICE) file format. In some embodiments, the circuit design 301 can be a standard cell design, for example, within a library of standard cells for the design characterization tool 300 to characterize.

The design characterization tool 300 can receive process variation information 302 describing manufacturing parameters, such as oxide thickness, oxide length, or the like, and how those parameters can vary during manufacturing. In some embodiments, the process variation information 302 can describe statistical conditions for manufacturing the circuit design 301 by defining a distribution of values for the manufacturing parameters, for example, having ranges of different potential oxide thicknesses, oxides lengths, or the like, and probabilities that a manufactured integrated circuit associated with the circuit design 301 falls at different locations in the ranges. The design characterization tool 300, in some embodiments, can receive at least a portion of the process variation information 302 from an analog simulation system 350. For example, the analog simulation system 350 can receive the circuit design 301, identify process variables, such as the manufacturing parameters, from the circuit design 301, and generate measurements for various portions of transistors in the circuit design 301. The identified process variables and the measurements can correspond to at least a portion of the process variation information 302. In some embodiments, the process variation information 302 can be specified in a SPICE file format.

The design characterization tool 300 can include a sampling system 310 that, in a block 401 of Figure 4, can sample the distribution of values for the manufacturing parameters in the process variation information 302. In some embodiments, each of the samples can be a Monte Carlo sample randomly drawn from the distribution of values for the manufacturing parameters.

The design characterization tool 300 can include a surrogate modeling system 320 that, in a block 402 of Figure 4, can generate a surrogate model 304 that approximates an output response of the circuit design 301 to variability of the manufacturing parameters described in the process variation information 302. The surrogate model 304, when simulated with different sets of manufacturing variations, can provide an output response similar to an output response of the circuit design 301 simulated with the same sets of the manufacturing variations, and the analog simulation system 350 can simulate the surrogate model 304 more quickly than the circuit design 301. In some embodiments, the surrogate model 304 can be a simple linear regression model, polynomial model, a piece-wise linear regression model, or the like.

The surrogate modeling system 320 can receive training samples of a manufacturing variation distribution, for example, from the sampling system 310. In some embodiments, each of the training samples can be a Monte Carlo sample randomly drawn from the distribution of values for the manufacturing parameters.

The surrogate modeling system 320 can direct the analog simulation system 350 to iteratively set the manufacturing parameters of a circuit design 301, such as circuit design 301, to correspond to the different training samples and simulate the circuit design 301 set with the different training samples utilizing a test bench 303. The test bench 303 can define test stimulus, for example, clock signals, activation signals, power signals, control signals, data signals, or the like, that, when grouped, may form test bench transactions capable of prompting operation of the circuit design 301 in an analog simulation environment. In some embodiments, the test bench 303 can be written in an object-oriented programming language, for example, SystemVerilog or the like, that, when executed during elaboration, can dynamically generate test bench components for verification of the circuit design 301. A methodology library, for example, a Universal Verification Methodology (UVM) library, an Open Verification Methodology (OVM) library, an Advanced Verification Methodology (AVM) library, a Verification Methodology Manual (VMM) library, or the like, can be utilized as a base for creating the test bench 303. The surrogate modeling system 320 can generate the surrogate model 304 of the circuit design 301 based, at least in part, on the results of the simulation of the circuit design 301 set with the different training samples.

The surrogate model system 320, in a block 403, can simulate the surrogate model 304 with the samples 305 of the manufacturing variation distribution to generate predicted output values. The predicted output values can correspond to an output response of the surrogate model that can be similar to an output response of the circuit design 301 simulated with the same samples 305 of the manufacturing variations.

The design characterization tool 300 can include a distribution estimation system 330 to generate an output distribution model for the circuit design 301, which can estimate a distribution of output values of the circuit design 301 set with the range of the manufacturing variation distribution. The distribution estimation system 330 can estimate the distribution of the output values of the circuit design 301 without having to simulate a full set of the Monte Carlo samples and thus saving time.

The distribution estimation system 330 can include a quantile selection system 332 that, in a block 404 of Figure 4, can order the samples 305 of the manufacturing variation distribution based on the predicted output values generated by the surrogate model 304 for the circuit design 301. The distribution estimation system 330 can compute predicted outputs by the surrogate model 304 having variations set based on the samples 305 and utilize the predicted outputs to order the samples 305 corresponding to a magnitude of the predicted output values.

The quantile selection system 332, in a block 405 of Figure 4, can assign quantiles to the ordered samples of the manufacturing variation distribution having been ordered based on the predicted output values from the surrogate model 304. The quantile selection system 332, in some embodiments, can assign each of the ordered samples a normal quantile, such as a sigma value, based on normal order statistic medians for a Monte Carlo sample of that size, for example, similar as can done when generating a normal probability plot.

The quantile selection system 332, in a block 406 of Figure 4, can select a subset of the samples 305 based on the assigned quantiles. In some embodiments, the quantile selection system 332 can select the samples 305 evenly spaced in the normal quantiles to be the subset of the samples 305. For example, when the normal quantiles correspond to sigma values, the quantile selection system 332 can select samples based on their corresponding sigma value. Since the distribution of the normal quantiles has a greater change of sigma values at the tail ends of the ordered samples, the quantile selection system 332 selection of the ordered samples based on the assigned quantiles can select samples 305 in the tails of the distribution more often than in the center of the distribution.

The analog simulation system 350, in a block 407 of Figure 4, can simulate the circuit design 305 with the subset of the samples of the manufacturing variation distribution and the distribution estimation system 330 can generate an output distribution model for the circuit design 301 based on the output values of the simulation. In some embodiments, the distribution estimation system 330 can generate the output distribution model by fitting a smooth, monotonic spline model of the output values of the simulation to the normal quantile of each sample. Since the distribution estimation system 330 can generate the output distribution model utilizing the predicted values from the surrogate model 304, the output distribution model can have a level of bias associated with inaccuracy of the predicted values generated by the surrogate model 304.

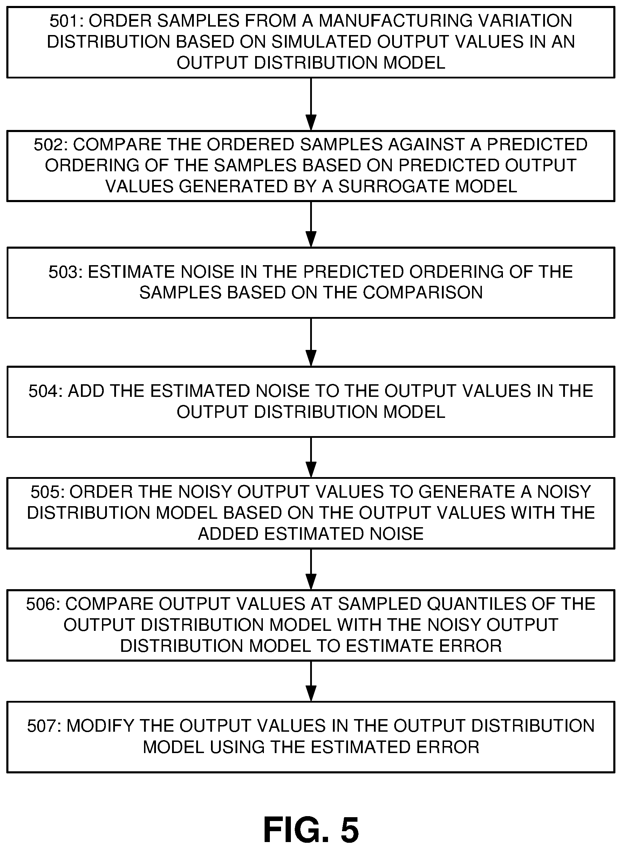

The design characterization tool 300 can include a bias correction system 334 to identify and correct bias in the output distribution model. The bias correction system 334, in a block 408 of Figure 4, can estimate an error in the order of the samples that was introduced by using the predicted output values and, in a block 409 of Figure 4, modify the output distribution model based on the estimated error in the order of the samples, which can correct bias in the output distribution model. In some embodiments, the bias correction system 334 can estimate the error by estimating a mean difference between a true normal quantile value of the distribution and the observed simulation values of the quantile sample with the same normal quantile and then correct the bias in the output distribution model by subtracting the mean difference from each quantile sample's simulated output value. The bias correction system 334 can fit a smooth monotonic spline model of the corrected response to the normal quantiles for each sample, which can correspond to the modified output distribution model having a bias corrected. Embodiments of estimating the error and correcting the bias will be described below in greater detail with reference to Figure 5.

The design characterization tool 300 can include a variation determination system 330 that, in a block 410 of Figure 4, can determine a variance measurement for the circuit design 301 based on the modified output distribution model. In some embodiments, the variation determination system 330 can utilize the modified output distribution model for the circuit design 301 to measure moments and 3 sigma quantiles for circuit design 301 in response to the manufacturing variability, which the design characterization tool 300 can output as a variability characterization 306 for the circuit design 301. For example, the variation determination system 330 can alter units in the output distribution model from normal quantiles to probabilities, which can correspond to a cumulative density function. In some embodiments, the variation determination system 330 can utilize the cumulative density function to generate Monte Carlo samples.

The variation determination system 330 also can determine a probability density function, for example, by taking a derivative of the cumulative density function, which the variation determination system 330 can use to evaluate moment equations, for example, by integrating them over the probability density function. The variation determination system 330 can specify the variability characterization 306 in a Liberty Variability Format (LVF), which can be an extension of a characterized circuit design 301 specified in a Liberty format.

Figure 5 illustrates a flowchart showing an example of error estimation in an ordering of samples and corresponding distribution model correction according to various examples. Referring to Figure 5, a design characterization tool, for example, implemented with the computing device 101 described in Figure 1, can, in a block 501, order samples from a manufacturing variation distribution based on simulated output values in an output distribution model. In some embodiments, the design characterization tool can simulate a circuit design with samples selected based on assigned quantiles to generate the simulated output values.

The design characterization tool, in a block 502, can compare the ordered samples against a predicted ordering of the samples based on predicted output values generated by a surrogate model. In some embodiments, the design characterization tool can utilize an ordering metric to compare the order of the samples based on the predicted output values against the order of the samples based on the simulated output values.

The design characterization tool, in a block 503, can estimate noise in the predicted ordering of the samples based on the comparison. In some embodiments, the design characterization tool can utilize the ordering metric to identify a model error in the predicted ordering of the samples as Gaussian random noise, for example, with a constant mean. The design characterization tool can select a magnitude or an amount of the noise based on a value of the ordering metric.

The design characterization tool, in a block 504, can add the estimated noise to the output values in the output distribution model. In some embodiments, the design characterization tool can sample the output distribution model and add the noise values to the output values associated with the samples, which can generate a new set of predicted output values.

The design characterization tool, in a block 505, can order the output values with the added estimated noise to generate the noisy output distribution model. In some embodiments, the design characterization tool can select a subset of samples, for example, corresponding to the quantile, from the samples ordered based on the noise-added output values, and look-up the output values in the output distribution model that correspond to the subset of the samples. The design characterization tool can generate the noisy output distribution model by fitting a smooth monotonic spline model with looked-up output values for the selected subset of the quantile samples.

The design characterization tool, in a block 506, can compare output values at sampled quantiles of the output distribution model with the noisy output distribution model to estimate error. In some embodiments, the design characterization tool can compare the noisy output values from the noisy output distribution model at each quantile to the output values from the output distribution model of each quantile to obtain an estimate of the error at each quantile. This process can be repeated for each of the noisy output values, which generates a distribution of errors at each quantile. At each quantile, the design characterization tool can determine a mean of these errors, which can be an expected value of the estimated error in the output distribution model at each quantile.

The design characterization tool, in a block 507, can modify the output values in the output distribution model using the estimated error. In some embodiments, the design characterization tool can subtract the estimated error from the output values in the output distribution model, which can correct the bias, and then fitting a smooth monotonic spline model for the error-corrected output values.

The system and apparatus described above may use dedicated processor systems, micro controllers, programmable logic devices, microprocessors, or any combination thereof, to perform some or all of the operations described herein. Some of the operations described above may be implemented in software and other operations may be implemented in hardware. Any of the operations, processes, and/or methods described herein may be performed by an apparatus, a device, and/or a system substantially similar to those as described herein and with reference to the illustrated figures.

The processing device may execute instructions or "code" stored in memory. The memory may store data as well. The processing device may include, but may not be limited to, an analog processor, a digital processor, a microprocessor, a multi-core processor, a processor array, a network processor, or the like. The processing device may be part of an integrated control system or system manager, or may be provided as a portable electronic device configured to interface with a networked system either locally or remotely via wireless transmission.

The processor memory may be integrated together with the processing device, for example RAM or FLASH memory disposed within an integrated circuit microprocessor or the like. In other examples, the memory may comprise an independent device, such as an external disk drive, a storage array, a portable FLASH key fob, or the like. The memory and processing device may be operatively coupled together, or in communication with each other, for example by an I/O port, a network connection, or the like, and the processing device may read a file stored on the memory. Associated memory may be "read only" by design (ROM) by virtue of permission settings, or not. Other examples of memory may include, but may not be limited to, WORM, EPROM, EEPROM, FLASH, or the like, which may be implemented in solid state semiconductor devices. Other memories may comprise moving parts, such as a known rotating disk drive. All such memories may be "machine-readable" and may be readable by a processing device.

Operating instructions or commands may be implemented or embodied in tangible forms of stored computer software (also known as "computer program" or "code"). Programs, or code, may be stored in a digital memory and may be read by the processing device. "Computer-readable storage medium" (or alternatively, "machine-readable storage medium") may include all of the foregoing types of memory, as well as new technologies of the future, as long as the memory may be capable of storing digital information in the nature of a computer program or other data, at least temporarily, and as long at the stored information may be "read" by an appropriate processing device. The term "computer-readable" may not be limited to the historical usage of "computer" to imply a complete mainframe, minicomputer, desktop or even laptop computer. Rather, "computer-readable" may comprise storage medium that may be readable by a processor, a processing device, or any computing system. Such media may be any available media that may be locally and/or remotely accessible by a computer or a processor, and may include volatile and non-volatile media, and removable and non-removable media, or any combination thereof.

A program stored in a computer-readable storage medium may comprise a computer program product. For example, a storage medium may be used as a convenient means to store or transport a computer program. For the sake of convenience, the operations may be described as various interconnected or coupled functional blocks or diagrams. However, there may be cases where these functional blocks or diagrams may be equivalently aggregated into a single logic device, program or operation with unclear boundaries.

### Conclusion

While the application describes specific examples of carrying out embodiments of the invention, those skilled in the art will appreciate that there are numerous variations and permutations of the above described systems and techniques that fall within the scope of the invention as set forth in the appended claims. For example, while specific terminology has been employed above to refer to design processes, it should be appreciated that various examples of the invention may be implemented using any desired combination of electronic design automation processes.

One of skill in the art will also recognize that the concepts taught herein can be tailored to a particular application in many other ways. In particular, those skilled in the art will recognize that the illustrated examples are but one of many alternative implementations that will become apparent upon reading this disclosure.

Although the specification may refer to "an", "one", "another", or "some" example(s) in several locations, this does not necessarily mean that each such reference is to the same example(s), or that the feature only applies to a single example.

## Claims

1. A method comprising:
sampling (401), by a computing system, a distribution of values for manufacturing variation of an integrated circuit described by a circuit design (301) and thus achieving samples (305);
ordering (404), by the computing system, the samples (305) based on predicted output values of the circuit design (301);
simulating (407), by the computing system, the circuit design (301) utilizing a subset of the samples (305) of values for manufacturing variation to identify simulated output values for an output distribution model;
estimating (408), by the computing system, an error in the order of the samples (305) associated with the predicted outputs of the circuit design (301) based, at least in part, on the simulated output values in the output distribution model; and
modifying (409), by the computing system, the output distribution model to correct a bias based, at least in part, on the estimated error in the order of the samples (305), wherein the modified output distribution is utilized to characterize operational variation of the circuit design (301) to the manufacturing variation described in the distribution of the values.

2. The method of claim 1, wherein the subset of the samples (305) of the values for the manufacturing variation correspond to normal quantiles of the ordered samples (305).

3. The method of claim 1, wherein estimating (408) the error in the order of the samples (305) associated with the predicted outputs of the circuit design (301) further comprises:
comparing the order of the samples (305) associated with the predicted outputs against an order of the samples (305) associated with the simulated output values; and
determining noise in the predicted output values based on the order of the samples (305) associated with the predicted outputs.

4. The method of claim 3, wherein modifying (409) the output distribution model further comprises:
adding (504) the determined noise in the order of the samples (305) to the simulated output values to generate a noisy distribution model;
determining (506) mean differences between output values for quantile samples in the output distribution model and the noisy distribution model; and
modifying (507) the output distribution model based on the mean differences between output values for the quantile samples.

5. The method of claim 1, further comprising:
generating (402), by the computing system, a surrogate model (304) of the circuit design (301) by simulating the circuit design (301) with a set of training samples from the distribution of values for the manufacturing variation; and
generating (403), by the computing system, the predicted output values of the circuit design (301) utilizing the surrogate model (304) of the circuit design (301).

6. The method of claim 1, wherein the distribution of values includes a probability distribution for occurrences of parameter values during a manufacturing process for the integrated circuit described by the circuit design (301).

7. The method of claim 1, further comprising performing a static timing analysis of the circuit design (301) utilizing the characterization of the operational variation of the circuit design (301).

8. An apparatus comprising at least one computer-readable memory device storing instructions configured to cause one or more processing devices to perform operations comprising:
sampling a distribution of values for manufacturing variation of an integrated circuit described by a circuit design (301) and thus achieving samples (305);
ordering the samples (305) based on predicted output values of the circuit design (301);
simulating the circuit design (301) utilizing a subset of the samples (305) of values for manufacturing variation to identify simulated output values for an output distribution model;
estimating an error in the order of the samples (305) associated with the predicted outputs of the circuit design (301) based, at least in part, on the simulated output values in the output distribution model; and
modifying the output distribution model to correct a bias based, at least in part, on the estimated error in the order of the samples (305), wherein the modified output distribution is utilized to characterize operational variation of the circuit design (301) to the manufacturing variation described in the distribution of the values.

9. The apparatus of claim 8, wherein the subset of the samples (305) of the values for the manufacturing variation correspond to normal quantiles of the ordered samples (305).

10. The apparatus of claim 8, wherein the instructions are configured to cause one or more processing devices to perform operations further comprising estimating the error in the order of the samples (305) associated with the predicted outputs of the circuit design (301) by:
comparing the order of the samples (305) associated with the predicted outputs against an order of the samples (305) associated with the simulated output values; and
determining noise in the predicted output values based on the order of the samples (305) associated with the predicted outputs.

11. The apparatus of claim 10, wherein the instructions are configured to cause one or more processing devices to perform operations further comprising modifying the output distribution model by:
adding the determined noise in the order of the samples (305) to the simulated output values to generate a noisy distribution model;
determining mean differences between output values for quantile samples in the output distribution model and the noisy distribution model; and
modifying the output distribution model based on the mean differences between output values for the quantile samples.

12. The apparatus of claim 8, wherein the instructions are configured to cause one or more processing devices to perform operations further comprising:
generating a surrogate model (304) of the circuit design (301) by simulating the circuit design (301) with a set of training samples from the distribution of values for the manufacturing variation; and
utilizing the surrogate model (304) of the circuit design (301) to generate the predicted output values of the circuit design (301).

13. The apparatus of claim 8, wherein the distribution of values includes a probability distribution for occurrences of parameter values during a manufacturing process for the integrated circuit described by the circuit design (301).

14. The apparatus of claim 8, wherein the instructions are configured to cause one or more processing devices to perform operations further comprising performing a static timing analysis of the circuit design (301) utilizing the characterization of the operational variation of the circuit design (301).

15. A system comprising a computing system and a memory system, the computing system comprising one or more processing devices, and the memory system comprising the apparatus according to any one of claims 8-14, wherein the computing system is configured to execute the instructions stored in the at least one computer-readable memory device.

## Patentansprüche

1. Verfahren, umfassend:
Abtasten (401), durch ein Rechensystem, einer Verteilung von Werten zur Herstellungsvariation einer integrierten Schaltung, die durch ein Schaltungsdesign (301) beschrieben wird, und somit Erzielen von Abtastwerten (305);
Ordnen (404), durch das Rechensystem, der Abtastwerte (305) basierend auf vorhergesagten Ausgabewerten des Schaltungsdesigns (301);
Simulieren (407), durch das Rechensystem, des Schaltungsdesigns (301) unter Nutzung einer Teilmenge der Abtastwerte (305) von Werten zur Herstellungsvariation, um simulierte Ausgabewerte für ein Ausgabeverteilungsmodell zu identifizieren;
Schätzen (408), durch das Rechensystem, eines Fehlers in der Reihenfolge der Abtastwerte (305), die mit den vorhergesagten Ausgaben des Schaltungsdesigns (301) assoziiert sind, mindestens teilweise basierend auf den simulierten Ausgabewerten im Ausgabeverteilungsmodell und
Modifizieren (409), durch das Rechensystem, des Ausgabeverteilungsmodells zum Korrigieren eines Bias mindestens teilweise basierend auf dem geschätzten Fehler in der Reihenfolge der Abtastwerte (305), wobei die modifizierte Ausgabeverteilung genutzt wird, um eine Betriebsvariation des Schaltungsdesigns (301) mit der Herstellungsvariation, die in der Verteilung der Werte beschrieben wird, zu charakterisieren.

2. Verfahren nach Anspruch 1, wobei die Teilmenge der Abtastwerte (305) der Werte für die Herstellungsvariation normalen Quantilen der geordneten Abtastwerte (305) entspricht.

3. Verfahren nach Anspruch 1, wobei das Schätzen (408) des Fehlers in der Reihenfolge der Abtastwerte (305), die mit den vorhergesagten Ausgaben des Schaltungsdesigns (301) assoziiert sind, ferner umfasst:
Vergleichen der Reihenfolge der Abtastwerte (305), die mit den vorhergesagten Ausgaben assoziiert sind, mit einer Reihenfolge der Abtastwerte (305), die mit den simulierten Ausgabewerten assoziiert sind; und
Bestimmen von Rauschen in den vorhergesagten Ausgabewerten basierend auf der Reihenfolge der Abtastwerte (305), die mit den vorhergesagten Ausgaben assoziiert sind.

4. Verfahren nach Anspruch 3, wobei ein Modifizieren (409) des Ausgabeverteilungsmodells ferner umfasst:
Addieren (504) des bestimmten Rauschens in der Reihenfolge der Abtastwerte (305) zu den simulierten Ausgabewerten, um ein verrauschtes Verteilungsmodell zu erzeugen;
Bestimmen (506) mittlerer Differenzen zwischen Ausgabewerten für Quantilabtastwerte im Ausgabeverteilungsmodell und im verrauschten Verteilungsmodell und
Modifizieren (507) des Ausgabeverteilungsmodells basierend auf den mittleren Differenzen zwischen Ausgabewerten für die Quantilabtastwerte.

5. Verfahren nach Anspruch 1, ferner umfassend:
Erzeugen (402), durch das Rechensystem, eines Ersatzmodells (304) des Schaltungsdesigns (301) durch Simulieren des Schaltungsdesigns (301) mit einem Satz von Trainingsabtastwerten aus der Verteilung von Werten für die Herstellungsvariation und
Erzeugen (403), durch das Rechensystem, der vorhergesagten Ausgabewerte des Schaltungsdesigns (301) unter Nutzung des Ersatzmodells (304) des Schaltungsdesigns (301).

6. Verfahren nach Anspruch 1, wobei die Verteilung von Werten eine Wahrscheinlichkeitsverteilung für Fälle des Auftretens von Parameterwerten während eines Herstellungsprozesses für die integrierte Schaltung, die durch das Schaltungsdesign (301) beschrieben wird, beinhaltet.

7. Verfahren nach Anspruch 1, das ferner ein Durchführen einer statischen Timing-Analyse des Schaltungsdesigns (301) unter Nutzung der Charakterisierung der Betriebsvariation des Schaltungsdesigns (301) umfasst.

8. Einrichtung, die mindestens eine computerlesbare Speichervorrichtung umfasst, die Anweisungen speichert, die dazu ausgelegt sind, eine oder mehrere Verarbeitungsvorrichtung(en) zum Durchführen von Operationen zu veranlassen, die umfassen:
Abtasten einer Verteilung von Werten zur Herstellungsvariation einer integrierten Schaltung, die durch ein Schaltungsdesign (301) beschrieben wird, und somit Erzielen von Abtastwerten (305);
Ordnen der Abtastwerte (305) basierend auf vorhergesagten Ausgabewerten des Schaltungsdesigns (301);
Simulieren des Schaltungsdesigns (301) unter Nutzung einer Teilmenge der Abtastwerte (305) von Werten zur Herstellungsvariation, um simulierte Ausgabewerte für ein Ausgabeverteilungsmodell zu identifizieren;
Schätzen eines Fehlers in der Reihenfolge der Abtastwerte (305), die mit den vorhergesagten Ausgaben des Schaltungsdesigns (301) assoziiert sind, mindestens teilweise basierend auf den simulierten Ausgabewerten im Ausgabeverteilungsmodell und
Modifizieren des Ausgabeverteilungsmodells zum Korrigieren eines Bias mindestens teilweise basierend auf dem geschätzten Fehler in der Reihenfolge der Abtastwerte (305), wobei die modifizierte Ausgabeverteilung genutzt wird, um eine Betriebsvariation des Schaltungsdesigns (301) mit der Herstellungsvariation, die in der Verteilung der Werte beschrieben wird, zu charakterisieren.

9. Einrichtung nach Anspruch 8, wobei die Teilmenge der Abtastwerte (305) der Werte für die Herstellungsvariation normalen Quantilen der geordneten Abtastwerte (305) entspricht.

10. Einrichtung nach Anspruch 8, wobei die Anweisungen dazu ausgelegt sind, eine oder mehrere Verarbeitungsvorrichtung(en) zu veranlassen, Operationen durchzuführen, die ferner ein Schätzen des Fehlers in der Reihenfolge der Abtastwerte (305), die mit den vorhergesagten Ausgaben des Schaltungsdesigns (301) assoziiert sind, umfassen, durch:
Vergleichen der Reihenfolge der Abtastwerte (305), die mit den vorhergesagten Ausgaben assoziiert sind, mit einer Reihenfolge der Abtastwerte (305), die mit den simulierten Ausgabewerten assoziiert sind; und
Bestimmen von Rauschen in den vorhergesagten Ausgabewerten basierend auf der Reihenfolge der Abtastwerte (305), die mit den vorhergesagten Ausgaben assoziiert sind.

11. Einrichtung nach Anspruch 10, wobei die Anweisungen dazu ausgelegt sind, eine oder mehrere Verarbeitungsvorrichtung(en) zu veranlassen, Operationen durchzuführen, die ferner ein Modifizieren des Ausgabeverteilungsmodells umfassen, durch:
Addieren des bestimmten Rauschens in der Reihenfolge der Abtastwerte (305) zu den simulierten Ausgabewerten, um ein verrauschtes Verteilungsmodell zu erzeugen;
Bestimmen mittlerer Differenzen zwischen Ausgabewerten für Quantilabtastwerte im Ausgabeverteilungsmodell und im verrauschten Verteilungsmodell und
Modifizieren des Ausgabeverteilungsmodells basierend auf den mittleren Differenzen zwischen Ausgabewerten für die Quantilabtastwerte.

12. Einrichtung nach Anspruch 8, wobei die Anweisungen dazu ausgelegt sind, eine oder mehrere Verarbeitungsvorrichtung(en) zu veranlassen, Operationen durchzuführen, die ferner umfassen:
Erzeugen eines Ersatzmodells (304) des Schaltungsdesigns (301) durch Simulieren des Schaltungsdesigns (301) mit einem Satz von Trainingsabtastwerten aus der Verteilung von Werten für die Herstellungsvariation und
Nutzen des Ersatzmodells (304) des Schaltungsdesigns (301), um die vorhergesagten Ausgabewerte des Schaltungsdesigns (301) zu erzeugen.

13. Einrichtung nach Anspruch 8, wobei die Verteilung von Werten eine Wahrscheinlichkeitsverteilung für Fälle des Auftretens von Parameterwerten während eines Herstellungsprozesses für die integrierte Schaltung, die durch das Schaltungsdesign (301) beschrieben wird, beinhaltet.

14. Einrichtung nach Anspruch 8, wobei die Anweisungen dazu ausgelegt sind, eine oder mehrere Verarbeitungsvorrichtung(en) zu veranlassen, Operationen durchzuführen, die ferner ein Durchführen einer statischen Timing-Analyse des Schaltungsdesigns (301) unter Nutzung der Charakterisierung der Betriebsvariation des Schaltungsdesigns (301) umfassen.

15. System, das ein Rechensystem und ein Speichersystem umfasst, wobei das Rechensystem eine oder mehrere Verarbeitungsvorrichtung(en) umfasst und das Speichersystem die Einrichtung nach einem der Ansprüche 8 bis 14 umfasst, wobei das Rechensystem dazu ausgelegt ist, die in der mindestens einen computerlesbaren Speichervorrichtung gespeicherten Anweisungen auszuführen.

## Revendications

1. Procédé comprenant les étapes suivantes :
échantillonner (401), par un système informatique, une distribution de valeurs pour fabriquer une variation d'un circuit intégré décrit par une conception de circuit (301) et ainsi obtenir des échantillons (305) ;
ordonner (404), par le système informatique, les échantillons (305) en fonction de valeurs de sortie prédites de la conception de circuit (301) ;
simuler (407), par le système informatique, la conception de circuit (301) utilisant un sous-ensemble des échantillons (305) de valeurs pour une variation de fabrication afin d'identifier des valeurs de sortie simulées pour un modèle de distribution de sortie ;
estimer (408), par le système informatique, une erreur dans l'ordre des échantillons (305) associés aux sorties prédites de la conception de circuit (301) sur la base, au moins en partie, des valeurs de sortie simulées dans le modèle de distribution de sortie ; et
modifier (409), par le système informatique, le modèle de distribution de sortie pour corriger un biais basé, au moins en partie, sur l'erreur estimée dans l'ordre des échantillons (305), la distribution de sortie modifiée étant utilisée pour caractériser la variation opérationnelle de la conception de circuit (301) par rapport à la variation de fabrication décrite dans la distribution des valeurs.

2. Procédé selon la revendication 1, dans lequel le sous-ensemble des échantillons (305) des valeurs pour la variation de fabrication correspond à des quantiles normaux des échantillons ordonnés (305).

3. Procédé selon la revendication 1, dans lequel l'estimation (408) de l'erreur dans l'ordre des échantillons (305) associés aux sorties prédites de la conception de circuit (301) comprend en outre les étapes suivantes :
comparer l'ordre des échantillons (305) associés aux sorties prédites à l'ordre des échantillons (305) associés aux valeurs de sortie simulées ; et
déterminer le bruit dans les valeurs de sortie prédites sur la base de l'ordre des échantillons (305) associés aux sorties prédites.

4. Procédé selon la revendication 3, dans lequel la modification (409) du modèle de distribution de sortie comprend en outre les étapes suivantes :
ajouter (504) le bruit déterminé dans l'ordre des échantillons (305) aux valeurs de sortie simulées afin de générer un modèle de distribution bruité ;
déterminer (506) des différences moyennes entre les valeurs de sortie pour des échantillons de quantiles dans le modèle de distribution de sortie et le modèle de distribution bruité ; et
modifier (507) du modèle de distribution de sortie sur la base des différences moyennes entre les valeurs de sortie pour les échantillons de quantiles.

5. Procédé selon la revendication 1, comprenant en outre les étapes suivantes :
générer (402), par le système informatique, un modèle de substitution (304) de la conception de circuit (301) en simulant la conception de circuit (301) avec un ensemble d'échantillons d'apprentissage à partir de la distribution de valeurs pour la variation de fabrication ; et
générer (403), par le système informatique, les valeurs de sortie prédites de la conception de circuit (301) à l'aide du modèle de substitution (304) de la conception de circuit (301).

6. Procédé selon la revendication 1, dans lequel la distribution des valeurs comprend une distribution de probabilité pour les occurrences de valeurs de paramètres au cours d'un processus de fabrication du circuit intégré décrit par la conception du circuit (301).

7. Procédé selon la revendication 1, comprenant en outre d'exécuter une analyse de synchronisation statique de la conception du circuit (301) utilisant la caractérisation de la variation opérationnelle de la conception du circuit (301).

8. Appareil comprenant au moins un dispositif de mémoire lisible par ordinateur stockant des instructions configurées pour amener un ou plusieurs dispositifs de traitement à réaliser des opérations comprenant les étapes suivantes :
échantillonner une distribution de valeurs pour fabriquer une variation d'un circuit intégré décrit par une conception de circuit (301) et ainsi obtenir des échantillons (305) ;
ordonner les échantillons (305) en fonction de valeurs de sortie prédites de la conception de circuit (301) ;
simuler la conception de circuit (301) utilisant un sous-ensemble des échantillons (305) de valeurs pour une variation de fabrication afin d'identifier des valeurs de sortie simulées pour un modèle de distribution de sortie ;
estimer une erreur dans l'ordre des échantillons (305) associés aux sorties prédites de la conception de circuit (301) sur la base, au moins en partie, des valeurs de sortie simulées dans le modèle de distribution de sortie ; et
modifier le modèle de distribution de sortie pour corriger un biais basé, au moins en partie, sur l'erreur estimée dans l'ordre des échantillons (305), la distribution de sortie modifiée étant utilisée pour caractériser la variation opérationnelle de la conception de circuit (301) par rapport à la variation de fabrication décrite dans la distribution des valeurs.

9. Appareil selon la revendication 8, dans lequel le sous-ensemble des échantillons (305) des valeurs pour la variation de fabrication correspond à des quantiles normaux des échantillons ordonnés (305).

10. Appareil selon la revendication 8, dans lequel les instructions sont configurées pour amener un ou plusieurs dispositifs de traitement à réaliser des opérations comprenant en outre d'estimer l'erreur dans l'ordre des échantillons (305) associés aux sorties prédites de la conception de circuit (301) en exécutant les étapes suivantes :
comparer l'ordre des échantillons (305) associés aux sorties prédites à l'ordre des échantillons (305) associés aux valeurs de sortie simulées ; et
déterminer le bruit dans les valeurs de sortie prédites sur la base de l'ordre des échantillons (305) associés aux sorties prédites.

11. Appareil selon la revendication 10, dans lequel les instructions sont configurées pour amener un ou plusieurs dispositifs de traitement à réaliser des opérations comprenant en outre de modifier le modèle de distribution de sortie en exécutant les étapes suivantes :
ajouter le bruit déterminé dans l'ordre des échantillons (305) aux valeurs de sortie simulées afin de générer un modèle de distribution bruité ;
déterminer des différences moyennes entre les valeurs de sortie pour des échantillons de quantiles dans le modèle de distribution de sortie et le modèle de distribution bruité ; et
modifier le modèle de distribution de sortie sur la base des différences moyennes entre les valeurs de sortie pour les échantillons de quantiles.

12. Appareil selon la revendication 8, dans lequel les instructions sont configurées pour amener un ou plusieurs dispositifs de traitement à réaliser des opérations comprenant en outre les étapes suivantes :
générer un modèle de substitution (304) de la conception de circuit (301) en simulant la conception de circuit (301) avec un ensemble d'échantillons d'apprentissage à partir de la distribution de valeurs pour la variation de fabrication ; et
utiliser le modèle de substitution (304) de la conception de circuit (301) pour générer les valeurs de sortie prédites de la conception de circuit (301).

13. Appareil selon la revendication 8, dans lequel la distribution des valeurs comprend une distribution de probabilité pour les occurrences de valeurs de paramètres au cours d'un processus de fabrication du circuit intégré décrit par la conception du circuit (301).

14. Appareil selon la revendication 8, dans lequel les instructions sont configurées pour amener un ou plusieurs dispositifs de traitement à réaliser des opérations comprenant en outre de réaliser une analyse de synchronisation statique de la conception du circuit (301) utilisant la caractérisation de la variation opérationnelle de la conception du circuit (301).

15. Système comprenant un système informatique et un système de mémoire, le système informatique comprenant un ou plusieurs dispositifs de traitement, et le système de mémoire comprenant l'appareil selon l'une quelconque des revendications 8 à 14, le système informatique étant configuré pour exécuter les instructions stockées dans l'au moins un dispositif de mémoire lisible par ordinateur.
